# EUROPÄISCHE PATENTSCHRIFT

(11) **EP 3 822 562 B1**
(45) Veröffentlichungstag und Bekanntmachung des Hinweises auf die Patenterteilung: **28.06.2023**
(21) Anmeldenummer: 20205596.8
(22) Anmeldetag: 04.11.2020
(51) Int. Cl.: F25D 23/02

(54) **KLIMASCHRANK**
CLIMATIC CABINET
ARMOIRE DE CLIMATISATION

(30) Priorität: 15.11.2019 DE 102019130848
(43) Veröffentlichungstag der Anmeldung: 19.05.2021
(73) Patentinhaber: Binder GmbH, 78532 Tuttlingen (DE)
(72) Erfinder: Husseck, Mario, 78050 Villingen-Schwenningen (DE); Seligmann, Nina, 78652 Deisslingen (DE); Moll, Jan, 78166 Donaueschingen (DE)
(74) Vertreter: Westphal, Mussgnug & Partner Patentanwälte mbB

(56) Entgegenhaltungen:
- WO-A1-2018/163365
- KR-B1- 101 830 091
- US-A1- 2004 177 591
- US-A1- 2006 248 824

## Beschreibung

Die vorliegende Erfindung betrifft einen Klimaschrank mit wenigstens einem eine Tür aufweisendes Gehäuse und einem Innenraum, der durch die wenigstens eine Tür verschließbar ist mit den Merkmalen des Patentanspruchs 1.

Klimaschränke sind aus dem Stand der Technik in unterschiedlichen Ausgestaltungen vorbekannt und werden in wissenschaftlichen Laboren oder im industriellen Einsatz zur Simulation von biologischen, chemischen und/oder physikalischen Umwelteinflüssen, wie beispielsweise Temperatur, Luftdruck und/oder Luftfeuchtigkeit verwendet. Ein Klimaschrank umfasst einen Innenraum und ein Gehäuse, wobei der Innenraum in dem Gehäuse angeordnet ist und in dem Innenraum die biologischen, chemischen und/oder physikalischen Umwelteinflüsse simuliert werden.

Die Türen der Klimaschränke ermöglichen nicht nur einen physischen Zugang zu dem Innenraum, sondern müssen ebenfalls als Wandung eine thermische Isolierung aufweisen, um den Innenraum von der Umgebung thermisch zu entkoppeln. Typischer Weise können Klimaschränke Temperaturen zwischen -10°C und 100° einstellen, jedoch gibt es ebenso Klimaschränke für den Hochtemperaturbereich, die dauerhaft Temperaturen von bis zu 350° im Innenraum einstellen können. Türen müssen dabei einerseits eine ausreichende Isolation aufweisen und weiterhin die Türfuge dicht verschließen, dass neben einem Wärmeaustausch mit der Umgebung auch ein Stoffaustausch unterbunden ist. Dazu ist in der Tür oder am Gehäuse eine Dichtung vorzusehen.

WO 2018 163365 A1 lehrt einen Kühlschrank gemäß dem Oberbegriff des Anspruchs 1 mit wenigstens einer Tür, die eine Innenwandung und einer Außenwandung umfasst. Die Innenwandung ist aus einem Kunststoff hergestellt.

KR 101 830 091 B1 lehrt eine Außenwandung eines Klimaschrankes aus einem biegbaren Grundkörper.

Als Nachteil der aus dem Stand der Technik bekannten Türen hat sich gezeigt, dass die Konstruktion der Tür eines Klimaschrankes aufwändig und ressourcenintensiv ist.

Die vorliegende Erfindung widmet sich daher der Aufgabe, einen Klimaschrank mit einer verbesserten Tür bereitzustellen, die in zweckmäßiger Weise die aus dem Stand der Technik bekannten Türen verbessert, den Herstellungsprozess vereinfacht und aufgrund von verbesserten Prozessen zu einer Kostenreduzierung beiträgt.

Diese Aufgaben werden durch einen Klimaschrank mit den Merkmalen des Patentanspruchs 1 gelöst.

Weitere vorteilhafte Ausgestaltungen der vorliegenden Erfindung werden in den Unteransprüchen angegeben.

Der erfindungsgemäße Klimaschrank mit den Merkmalen des Patentanspruchs 1 umfasst wenigstens ein eine Tür aufweisendes Gehäuse mit einem Innenraum, der durch die wenigstens eine Tür verschließbar ist. Die mindestens eine Tür weist eine Innenwandung und eine Außenwandung auf, wobei die Innenwandung aus einem einstückigen und biegbaren Grundkörper gebildet ist, der einen durch Seitenbereiche umgebenen mehreckigen Wandungsabschnitt aufweist. Von den Seitenbereichen steht jeweils eine Zunge mit einem freien Ende ab, wobei die jeweilige Zunge in einer ersten Kante zur Bildung einer Wanne von dem Wandungsabschnitt, bevorzugt um 90°, zu einem ersten Abschnitt von dem Wandungsabschnitt abgekantet ist. Um eine Dichtungsaufnahme auszubilden, in die eine Dichtung zum Verschließen einer Türfuge zwischen der Tür und dem Gehäuse einsetzbar ist, ist eine zweite Kante vorgesehen, die zu dem freien Ende der Zunge hin einen zweiten Abschnitt von dem ersten Abschnitt auf der dem Wandungsabschnitt abgewandten Seite des ersten Abschnitts zurückkantet.

Die Erfindung basiert auf der Idee, die Innenwandung aus einem einzigen Stück - bevorzugt durch Biegen - herzustellen, wobei die einzelnen Kanten der Innenwandung in einem computernumerisch gesteuerten Herstellungsverfahren (CNC) in den Grundkörper eingeformt werden. Es werden sowohl eine Wanne zur Aufnahme einer oder mehrerer thermisch isolierenden Schicht auf der einer Außenseite zugewandten Seite sowie eine Dichtungsaufnahme für die Türdichtung auf einer der Innenseite zugewandten Seite bereitgestellt. Dadurch kann die Anzahl der verwendeten Bauteile zur Herstellung einer Tür eines Klimaschranks erheblich reduziert werden, die Herstellungsschritte zu einem hohen Maße automatisiert werden, wodurch die Prozesssicherheit gesteigert werden kann und Kostenersparnisse erzielt werden können.

Unter den Seitenbereichen des mehreckigen Wandungsabschnitts werden die Bereiche verstanden, die entlang einer geraden Verbindungslinie zwischen den Ecken des Wandungsabschnittes ausgebildet sind.

In einer bevorzugten Weiterbildung der vorliegenden Erfindung ist der mehreckige Wandungsabschnitt viereckig ausgebildet und hat somit vier Ecken und vier Seitenbereiche. Bevorzugt schließen zwei benachbarte Seitenbereiche in einer Ecke einen Winkel von 90° ein.

Die jeweilige Zunge steht von dem jeweiligen Seitenbereich frei ab und weist bevorzugte eine konstante Länge auf, die einer Länge des jeweiligen Seitenbereichs entspricht. Die jeweilige Länge wird parallel zu der ersten Kante bzw. parallel zu dem zugehörigen Seitenbereich gemessen. Die Breite der jeweiligen Zunge, gemessen senkrecht zu der ersten Kante entspricht bevorzugt mindestens einer zweifachen Tiefe der Tür. Alle Zungen können die gleiche Breite aufweisen, während die Länge von der Form der Tür vorgeben wird. Entsprechend können die Zungen quaderförmig ausgebildet sein.

Gemäß einer weiteren vorteilhaften Ausgestaltung der vorliegenden Erfindung ist die zweite Kante derart abgekantet, dass der zweite Abschnitt näherungsweise parallel zu dem ersten Abschnitt und somit senkrecht zu dem Wandungsabschnitt angeordnet ist. Die beiden Abschnitte bilden eine stabile Wanne aus, in der die wenigstens eine Füllung oder Isolierschicht gehalten werden kann. Darüber hinaus versteift diese Anordnung des ersten Abschnitts und des zweiten Abschnitts die Tür.

Nach Maßgabe einer bevorzugten Weiterbildung der vorliegenden Erfindung sind eine dritte Kante und eine vierte Kante vorgesehen. Die dritte Kante winkelt zu dem freien Ende der Zunge hin einen dritten Abschnitt von dem zweiten Abschnitt ab und die vierte Kante winkelt zu dem freien Ende der Zunge hin einen vierten Abschnitt von dem dritten Abschnitt ab.

Bevorzugt ist es, wenn ein Abstand zwischen der ersten Kante und der zweiten Kante größer ist als ein Abstand zwischen der zweiten Kante und der dritten Kante, wodurch die dritte Kante auf einer Seite des Wandungsabschnitts positioniert ist, auf der auch die zweite Kante angeordnet ist.

Darüber hinaus hat es sich als vorteilhaft erwiesen, wenn die Dichtungsaufnahme im Querschnitt U-förmig ist und dass die Dichtungsaufnahme bereichsweise aus dem ersten Abschnitt, aus dem dritten Abschnitt und aus dem vierten Abschnitt ausgebildet ist.

Die dritte Kante winkelt bevorzugt den dritten Abschnitt von dem zweiten Abschnitt der Art ab, dass ein Boden für die Dichtungsaufnahme ausgebildet ist, der näherungsweise parallel zu dem Wandungsabschnitt ausgerichtet ist.

Weiterhin ist es bevorzugt, wenn der vierte Abschnitt näherungsweise parallel zu dem ersten Abschnitt und/oder dem zweiten Abschnitt angeordnet ist, wodurch der Querschnitt der Dichtungsaufnahme näherungsweise quaderförmig ist.

Eine vorteilhafte Weiterbildung der vorliegenden Erfindung sieht vor, dass eine fünfte Kante vorgesehen ist, die zu dem freien Ende der Zunge hin einen Endanschnitt ausbildet, der parallel zu dem Wandungsabschnitt, bevorzugt fluchtend zu dem Wandungsabschnitt, angeordnet ist. Der Endabschnitt ist konfiguriert, auf der Außenwandung aufzuliegen oder die Außenwandung zu überlappen und bildet den Übergang zwischen der Innenwandung und der Auswandung.

Darüber hinaus ist es vorteilhaft, wenn ein erster Abstand zwischen der ersten Kante und der zweiten Kante kleiner ist als die Summe des zweiten Abstands zwischen der zweiten Kante und der dritten Kante und eines vierten Abstands zwischen der vierten Kante und der fünften Kante, wobei die Abstände jeweils parallel zu dem ersten Abschnitt gemessen werden. Durch diese Bemessung der Abstände ist im montierten Zustand der Tür sichergestellt, dass keine Doppelpassung gebildet ist, und dass die Füllung formschlüssig in der Wanne zwischen der Außenwandung und der Innenwandung gehalten ist.

Nach Maßgabe einer weiteren Ausgestaltung der vorliegenden Erfindung sind in der Dichtungsaufnahme Befestigungsmittel vorgesehen, wobei die Befestigungsmittel vorzugsweise konfiguriert sind, eine Verbindung zwischen der Innenwandung und der Auswandung herzustellen. Insbesondere ist es bevorzugt, wenn die Befestigungsmittel in dem dritten Abschnitt, also in dem Boden der Dichtungsaufnahme, angeordnet sind und weiter bevorzugt Schrauben umfassen. Sobald die Dichtung in die Dichtungsaufnahme eingesetzt ist, werden die Befestigungsmittel durch die Dichtung verdeckt und sind nicht mehr ersichtlich. Auch verhindert die Dichtung ein Eindringen von Verschmutzungen in die Dichtungsaufnahme und zu dem Befestigungsmittel.

Weiterhin hat es sich als vorteilhaft erwiesen, wenn der erste Abschnitt und der zweite Abschnitt durch Verbindungsmittel miteinander verbunden sind. Insbesondere ist es bevorzugt, wenn die Verbindungsmittel in dem ersten Abschnitt zwischen der ersten Kante und der zweiten Kante und jeweils beabstandet zu diesen Kanten angeordnet sind, wobei bevorzugt der Abstand zwischen der ersten Kante kleiner ist als der Abstand zu der zweiten Kante, wodurch ein Aufbiegen der Dichtungsaufnahme verhindert werden soll. Bevorzugt sind die Verbindungsmittel aus Nieten oder Punktschweißungen ausgebildet, jedoch können auch andere Verbindungsmittel zur Anwendung kommen.

Auch kann in der Wanne eine Füllung angeordnet sein, die bevorzugt aus einem Kunststoff-Hartschaum hergestellt ist. Ein solcher Hartschaum kann beispielweise ein PUR- oder PIR-Schaum sein, der für einen hohen Wärmewiderstand bekannt ist. Die Füllung kann aus vorgefertigten Platten hergestellt sein, die weiterhin in der Wanne mittels temperaturbeständigem Kleber befestigt sein können. Auch kann die Füllung mehrschichtig und/oder aus unterschiedlichen Werkstoffen hergestellt sein, um für den entsprechenden Temperaturbereich des Klimaschrankes eine bestmöglich abgestimmte Isolation und Temperaturbeständigkeit bereitzustellen. Alternativ kann die Wanne im montierten Zustand der Tür ausgeschäumt werden, wobei gleichzeitig eine äußerst robuste Klebeverbindung zwischen der Innenwandung und der Außenwandung bewerkstelligt werden kann.

Gemäß einer weiteren bevorzugten Ausgestaltung der vorliegenden Erfindung sind, bzw. ist die Innenwand und/oder die Außenwand aus einem Edelstahl hergestellt. Edelstahl hat sich für Wandungen in Simulationsschränken bewährt, da dieser Werkstoff sowohl eine thermisch, chemisch als auch mechanisch beständige Oberfläche aufweist.

Bevorzugt werden die Außenwandung und die Innenwandung durch Biegen eines entsprechend geformten Grundkörpers erzeugt, wobei der Grundkörper als ein Stanzteil durch Stanzen bereitgestellt werden kann.

Nachfolgend wird unter Bezugnahme auf die begleitenden Zeichnungen ein erfindungsgemäßes Ausführungsbeispiel der Erfindung im Detail beschrieben. Es zeigen:
- Figur 1: eine perspektivische Darstellung einer Tür eines Klimaschrankes mit einer Außenwandung und einer Innenwandung,
- Figur 2: eine vergrößerte und teilweise geschnittene Darstellung der Tür des Klimaschrankes gemäß Figur 1,
- Figur 3: eine vergrößerte Schnittdarstellung der Innenwandung der Tür gemäß Figuren 1 und 2, wobei die Innenwandung durch mehrere Kanten eine Wanne und eine Dichtungsaufnahme für eine Dichtung ausbildet, und
- Figur 4: eine vergrößerte und perspektivische Darstellung der Innenwandung gemäß Figur 3.

Nachfolgend werden gleiche oder funktional gleiche Teile mit gleichen Bezugszeichen gekennzeichnet. Der Übersichtlichkeit halber sind in den einzelnen Figuren nicht alle gleichen oder funktional gleichen Teile mit einer Bezugsziffer versehen.

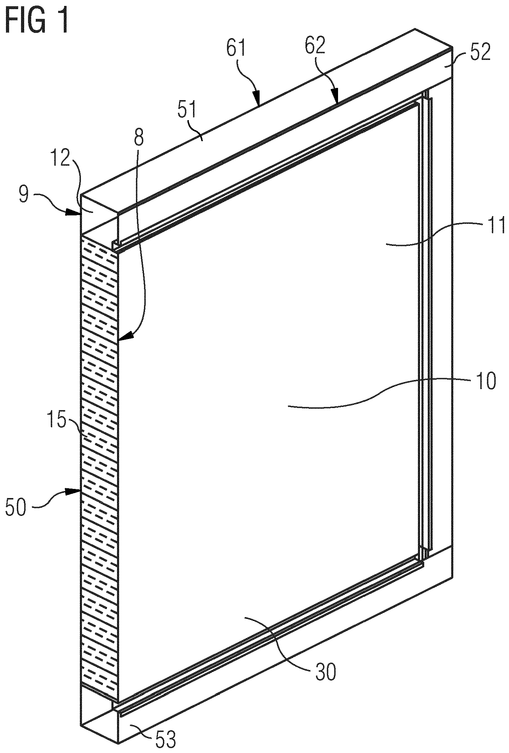

In Figur 1 ist eine Tür 10 eines nicht vollständig dargestellten Klimaschranks 1 gezeigt, durch die ein (nicht dargestellter) Innenraum eines (nicht dargestellten) Gehäuses eines Klimaschranks 1 verschließbar ist. Die Tür 10 weist eine Innenseite 8 und eine Außenseite 9 auf, wobei die Innenseite 8 dem Innenraum zugewandt ist und die Außenseite 9 der Umgebung.

Die Tür 10 weist eine Innenwandung 11 und eine Außenwandung 12 auf, die vorzugsweise jeweils aus einem plattenförmigen und biegbaren Grundkörper hergestellt werden kann. Der plattenförmige und biegbare Grundkörper kann aus einem Edelstahlblech hergestellt sein und - wie im Nachfolgenden detailliert beschrieben werden wird - mehrere Kanten 21, 22, 23, 24, 25, 61, 62 aufweisen, die durch ein Biegen, insbesondere CNC-Biegen, hergestellt sein können.

Die Außenwandung 12 bildet im Wesentlichen eine auf der Außenseite 9 der Tür 10 angeordnete Wandung und weist einen quaderförmigen Frontseitenabschnitt 50 auf, an dessen Seiten jeweils ein erster Rahmenabschnitt 51 und ein zweiter Rahmenabschnitt 52 angeordnet sind, die einen Rahmen 53 für die Aufnahme der Innenwandung 11 bilden.

Der erste Rahmenabschnitt 51 steht um eine erste Kante 61 abgewinkelt senkrecht von dem Frontseitenabschnitt 50 in Richtung der Innenseite 8 ab und bildet die Seitenwandung der Tür 10. Der zweite Rahmenabschnitt 52 ist parallel zum Frontseitenabschnitt 50 ausgebildet und mittels einer zweiten Kante 62 von dem ersten Rahmenabschnitt 51 abgewinkelt und durch diesen mit dem Frontseitenabschnitt 50 verbunden. Die erste Kante 61 und die zweite Kante 62 sind parallel und beabstandet zueinander ausgerichtet.

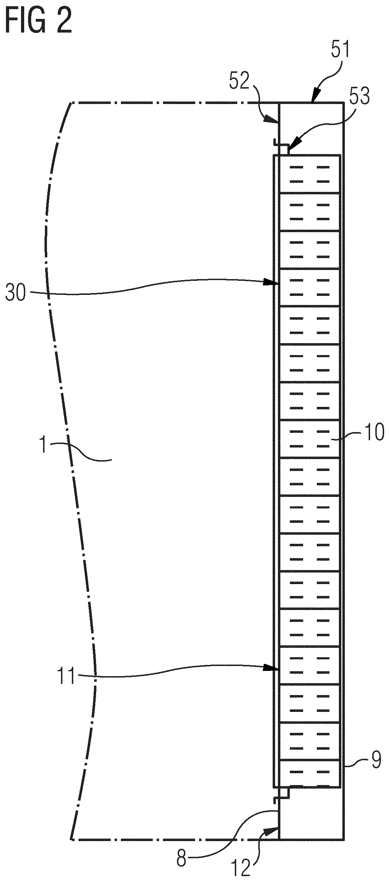

In Eckbereichen der Außenwandung 12 liegen zwei benachbarte zweite Rahmenabschnitte 52 übereinander, die zum Versteifen der Konstruktion miteinander verbunden sein können, insbesondere durch Nieten 55, siehe Figur 2.

Die beiden Rahmenabschnitte 51, 52 und der Frontseitenabschnitt 50 bilden eine im Querschnitt U-förmige Tasche, in der ein thermisch isolierender Werkstoff angeordnet werden kann.

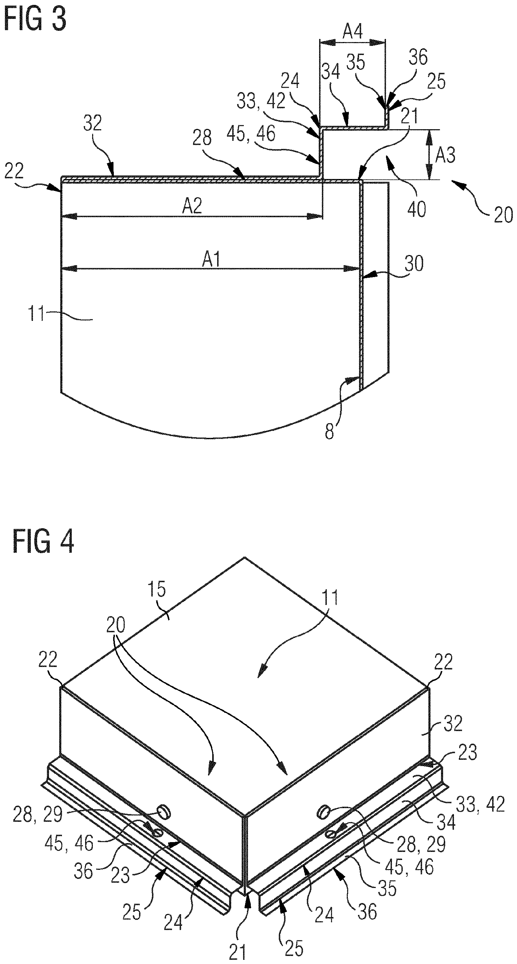

Die Innenwandung 11 weist unter Bezugnahme auf die Figuren 3 und 4 eine Mehrzahl von Kanten 21, 22, 23, 24 und 25 auf, die durch ein CNC-Biegen gebildet werden können. Zunächst wird zum Herstellen der Innenwandung 11 der plattenförmige und biegbare Grundkörper zur Verfügung gestellt. Der Grundkörper kann X-oder kreuzförmig ausgebildet sein und einen quaderförmigen Wandungsabschnitt 30 aufweisen, der von vier Seitenbereichen umgeben ist. Der jeweilige Seitenbereich ist definitionsgemäß zwischen zwei benachbarten Ecken des quaderförmigen Wandungsabschnitts 30 angeordnet. In jeder Ecke schließen zwei benachbarte Seitenbereiche einen rechten Winkel ein.

Von dem Wandungsabschnitt 30 steht an jedem Seitenbereich eine Zunge 20 frei ab. Die jeweilige Zunge 20 erstreckt sich vorzugsweise vollständig über den jeweiligen Seitenbereich, weshalb die Länge des Seitenbereichs im Wesentlichen der Länge der Zunge 20 entspricht. Die Zunge 20 weist ein freies Ende 36 auf, welches parallel und beanstandet zu dem Seitenbereich angeordnet ist. Entsprechend ist die Zunge 20 ebenfalls im Wesentlichen quaderförmig.

Figur 3 kann entnommen werden, dass die Innenwandung 11 eine Wanne 15 und eine Dichtungsaufnahme 40 ausbildet, wobei in der Wanne 15 eine (nicht dargestellte) Füllung angeordnet sein kann. Die Füllung kann aus einem thermisch isolierenden Werkstoff mit einem hohen Wärmewiderstand bzw. einer kleinen Wärmeleitfähigkeit λ, bevorzugt λ < 0,05 W/mK, hergestellt sein. Eine solche Füllung kann beispielsweise aus einem PUR-Werkstoff oder PIR-Werkstoff hergestellt sein.

Die Wanne 15 ist auf der der Außenseite 9 zugewandten Seite der Innenwandung 11 durch eine erste Kante 21 ausgebildet, wodurch die Zunge 20 näherungsweise in einem rechten Winkel in Richtung der Außenseite 9 abgekantet ist. Die erste Kante 21 kann mit einem Biegeradius gebogen werden. Auf der von dem Wandungsabschnitt 30 abgewandten Seite der ersten Kante 21 ist ein erster Abschnitt 31 der Zunge 20 ausgebildet. Die erste Kante 21 ist auf dem Seitenbereich des Wandungsabschnitts 30 ausgebildet.

In einem ersten Abstand A1 zu der ersten Kante 21 ist eine zweite Kante 22 angeordnet, die parallel und beabstandet zu der ersten Kante 21 verläuft. Um die zweite Kante 22 ist die Zunge 20 auf der dem Wandungsabschnitt 30 abgewandten Seite des ersten Abschnitts 21 zurückgekantet, d. h. die Zunge 20 ist in der zweiten Kante 22 um 180° zurückgeformt. Die zweite Kante 22 gibt die Tiefe der Wanne 15 vor.

Um ein scharfkantiges Biegen der zweiten Kante 22 zu erleichtern, kann vor dem Formen der zweiten Kante 22 eine Perforation 27 in die Zunge 20 eingearbeitet oder eingeformt sein. Die Perforation 27 ist insbesondere in den Figuren 3 und 4 gezeigt und es ist ersichtlich, dass zwischen Ausnehmungen schmale Verbindungsstege ausgebildet sind. Die Ausnehmungen können bei der Bereitstellung des Grundkörpers erzeugt werden.

Weiterhin ist der Figur 3 zu entnehmen, dass die Zunge 20 eine dritte Kante 23, eine vierte Kante 24 und eine fünfte Kante 25 aufweist.

Die dritte Kante 23 wird zur Ausbildung eines dritten Abschnittes 33 auf der von der ersten Kante 21 abgewandten Seite der zweiten Kante 22 und parallel zu der ersten Kante 21 und parallel zu der zweiten Kante 22 in einem zweiten Abstand A2 zu der zweiten Kante 22 ausgebildet. In der dritten Kante 23 ist die Zunge 20 um 90° mit einem Biegeradius abgekantet, womit der dritte Abschnitt 33 näherungsweise parallel zu dem Wandungsabschnitt 30 angeordnet ist und einen Boden 42 der Dichtungsaufnahme 40 bildet.

Die vierte Kante 24 ist auf der von der zweiten Kante 22 abgewandten Seite der dritten Kante 23 angeordnet und ebenfalls parallel zu der zweiten Kante 22 und der dritten Kante 23 in einem dritten Abstand A3 angeordnet. Die Zunge ist um die vierte Kante 24 ebenfalls näherungsweise um 90° gekantet und kann mit einem Biegeradius gebogen werden.

Weiterhin zeigt die vergrößerte Darstellung gemäß Figur 3, dass die Dichtungsaufnahme 40 bereichsweise durch den ersten Abschnitt 31, durch den dritten Abschnitt 33 und den vierten Abschnitt 34 gebildet ist und im Wesentlichen im Querschnitt U-förmig ist.

In einem fünften Abstand A5 ist auf der von der dritten Kante 23 abgewandten Seite der vierten Kante 24 die fünfte Kante 25 parallel zu den Kanten 21, 22, 23 und 24 angeordnet. Durch die fünfte Kante 25 wird an dem freien Ende 36 der Zunge 20 ein Endabschnitt 35 ausbildet, der - wie den Figuren 1 und 2 zu entnehmen ist - im montierten Zustand der Tür 10 den zweiten Rahmenabschnitt 52 der Außenwandung 12 überlappt. Die fünfte Kante 25 kann auch mit einem Biegeradius versehen sein.

In die im Wesentlichen U-förmige Dichtungsaufnahme 40 kann eine (nicht dargestellte) Dichtung eingesetzt werden. Um ein Aufbiegen der Dichtungsaufnahme 40 und somit ein Herausfallen der Dichtung zu verhindern, können Verbindungsmittel vorgesehen werden, durch die der erste Abschnitt 31 und der zweite Abschnitt 32 miteinander verbunden sind.

In dem dargestellten Ausführungsbeispiel ist zwischen der ersten Kante 21 und der zweiten Kante 22 in dem ersten Abschnitt 31 sowie in dem zweiten Abschnitt 32 zwischen der zweiten Kante 22 und der dritten Kante 23 jeweils eine Durchgangsbohrung 28 vorgesehen, die nach dem Formen der zweiten Kante 22 fluchtend zueinander ausgerichtet sind. In diese Durchgangsbohrungen 28 können beispielsweise Nieten 29 als Verbindungsmittel eingesetzt werden.

Der erste Abstand A1, also der Abstand zwischen der ersten Kante 21 und der zweiten Kante 22 ist größer als der zweite Abstand A2 zwischen der zweiten Kante 22 und der dritten Kante 23.

Der dritte Abstand A3 wird durch eine Breite der (nicht dargestellten) Dichtung vorgegeben und ist so dimensioniert, dass die Dichtung in der Dichtungsaufnahme 40 geklemmt gehalten werden kann.

Der vierte Abstand A4 gibt die Tiefe der Dichtungsaufnahme 40 vor und wird abermals durch die Dichtung vorgegeben. Die Summe des zweiten Abstandes A2 und des vierten Abstandes A4 kann so dimensioniert sein, dass die Summe näherungsweise dem ersten Abstand A1 entspricht. In dem dargestellten Ausführungsbeispiel liegt der Endabschnitt 35 im montierten Zustand der Tür 10 nicht auf dem zweiten Rahmenabschnitt auf, sondern steht auf der Innenseite 8 ab. In dieser bevorzugten Ausgestaltung gilt folgendes: A4 + A2 > A1.

Zur Herstellung der Tür 10 werden zunächst die plattenförmigen und biegbaren Grundkörper bereitgestellt und erfolgt vorzugsweise durch Stanzen. Anschließend werden die Innenwandung 11 und die Außenwandung 12 bevorzugt durch ein CNC-Biegen in die zuvor beschriebenen Formen umgeformt.

Nach dem Umformen wird zunächst die Füllung in die Wanne 15 eingesetzt und kann dort mittels eines Klebers befestigt werden. Alternativ oder ergänzend kann die Füllung in der Wanne 15 durch ein Ausschäumen mit einem Kunststoff-Hartschaum gebildet werden. Auch kann die Füllung lose in die Wanne 15 einsetzt werden.

Anschließend kann die so gebildete Einheit in den durch die Außenwandung 12 gebildeten Rahmen 53 eingesetzt werden, bis die zweite Kante 22 an dem Frontseitenabschnitt 50 der Außenwandung 12 anliegt und die Wanne 15 durch den Frontseitenabschnitt 50 der Außenwandung 12 verschlossen wird. Die Füllung der Wanne 15 wird somit vollständig umschlossen.

Die Innenwandung 11 und die Außenwandung 12 können durch Befestigungsmittel 45 miteinander verbunden werden. Hierzu können in den Boden 42 der Dichtungsaufnahme 40 Öffnungen 46 eingeformt oder eingearbeitet sein, in die beispielsweise (nicht dargestellte) Schrauben als Befestigungsmittel eingeführt werden können, die in ein entsprechendes Gegengewinde auf der der Innenwandung 11 zugewandten Seite der Außenwandung 12 eingreifen können. Sobald die Dichtung in die Dichtungsaufnahme 40 eingesetzt ist, sind die Befestigungsmittel verdeckt und können nicht mehr wahrgenommen werden.

### Bezugszeichenliste

- 1: Klimaschrank
- 8: Innenseite
- 9: Außenseite
- 10: Tür
- 11: Innenwandung
- 12: Außenwandung
- 15: Wanne
- 16: Füllung
- 20: Zunge
- 21: erste Kante
- 22: zweite Kante
- 23: dritte Kante
- 24: vierte Kante
- 25: fünfte Kante
- 27: Perforation
- 28: Durchgangsbohrung
- 29: Niete
- 30: Wandungsabschnitt
- 31: erster Abschnitt
- 32: zweiter Abschnitt
- 33: dritter Abschnitt
- 34: vierter Abschnitt
- 35: Endabschnitt
- 36: freies Ende von 20
- 40: Dichtungsaufnahme
- 42: Boden
- 45: Befestigungsmittel
- 46: Öffnung
- 50: Frontseitenabschnitt
- 51: erster Rahmenabschnitt
- 52: zweiter Rahmenabschnitt
- 53: Rahmen für Aufnahme von 11
- 61: erste Kante
- 62: zweite Kante

## Patentansprüche

1. Klimaschrank (1), umfassend
- wenigstens ein eine Tür (10) aufweisendes Gehäuse mit einem Innenraum, der durch die wenigstens eine Tür (10) verschließbar ist,
- wobei die wenigstens eine Tür (10) eine Innenwandung (11) und eine Außenwandung (12) aufweist,
- wobei die Innenwandung (11) aus einem einstückigen und biegbaren Grundkörper gebildet ist, der einen durch Seitenbereiche umgebenen mehreckigen Wandungsabschnitt (30) aufweist,
- **dadurch gekennzeichnet, dass** von den Seitenbereichen jeweils eine Zunge (20) mit einem freien Ende (36) absteht,
- wobei die Zunge (20) in einer ersten Kante (21) zur Bildung einer Wanne (15) in einen ersten Abschnitt (31) von dem Wandungsabschnitt (30) abgekantet ist,
- wobei das freie Ende (36) der Zunge (20) durch eine zweite Kante (22) in einen zweiten Abschnitt (32) zur Bildung einer Dichtungsaufnahme (40), in die eine Dichtung einsetzbar ist, zurückgekantet ist, und
- wobei die Wanne (15) zur Aufnahme einer oder mehrerer thermisch isolierenden Schichten auf der einer Außenseite (8) zugewandten Seite sowie die Dichtungsaufnahme (40) für die Türdichtung auf einer der Innenseite (7) zugewandten Seite angeordnet sind.

2. Klimaschrank (1) nach Anspruch 1,
**dadurch gekennzeichnet, dass**
der Wandungsabschnitt (30) quaderförmig ausgebildet ist und dass an vier Seitenbereichen jeweils eine Zunge (20) absteht.

3. Klimaschrank (1) nach Anspruch 1 oder 2,
**dadurch gekennzeichnet, dass**
die zweite Kante (22) derart abgekantet ist, dass der zweite Abschnitt (32) näherungsweise parallel zu dem ersten Abschnitt (21) angeordnet ist.

4. Klimaschrank (1) nach einem der Ansprüche 1 bis 3,
**dadurch gekennzeichnet, dass**
eine dritte Kante (23) und eine vierte Kante (24) vorgesehen sind, dass die dritte Kante (23) zu dem freien Ende (36) der Zunge (20) hin einen dritten Abschnitt (33) von dem zweiten Abschnitt (32) abtrennt, und dass die vierte Kante (24) zu dem freien Ende (36) der Zunge (20) hin einen vierten Abschnitt (34) von dem dritten Abschnitt (33) abwinkelt.

5. Klimaschrank (1) nach Anspruch 4,
**dadurch gekennzeichnet, dass**
ein erster Abstand (A1) zwischen der ersten Kante (21) und der zweiten Kante (22) größer ist als ein zweiter Abstand (A2) zwischen der zweiten Kante (22) und der dritten Kante (23).

6. Klimaschrank (1) nach Anspruch 4 oder 5,
**dadurch gekennzeichnet, dass**
die Dichtungsaufnahme (40) im Querschnitt U-förmig ist, und dass die Dichtungsaufnahme (40) bereichsweise aus dem ersten Abschnitt (31), aus dem dritten Abschnitt (33) und aus dem vierten Abschnitt (34) gebildet ist.

7. Klimaschrank (1) nach einem der Ansprüche 4 bis 6,
**dadurch gekennzeichnet, dass**
der dritte Abschnitt (33) einen Boden (42) der Dichtungsaufnahme (40) bildet und näherungsweise parallel zu dem Wandungsabschnitt (30) angeordnet ist.

8. Klimaschrank (1) nach einem der Ansprüche 4 bis 7,
**dadurch gekennzeichnet, dass**
der vierte Abschnitt (34) näherungsweise parallel zu dem ersten Abschnitt (31) und/oder dem zweiten Abschnitt (32) angeordnet ist.

9. Klimaschrank (1) nach einem der vorgenannten Ansprüche, **dadurch gekennzeichnet, dass**
eine fünfte Kante (25) vorgesehen ist, die zu dem freien Ende (36) der Zunge (20) hin einen Endabschnitt (35) ausbildet, der parallel zu dem Wandungsabschnitt (30), angeordnet ist.

10. Klimaschrank (1) nach einem der Ansprüche 4 bis 9,
**dadurch gekennzeichnet, dass**
ein erster Abstand (A1) zwischen der ersten Kante (21) und der zweiten Kante (22) kleiner ist als die Summe eines zweiten Abstandes (A2) zwischen der zweiten Kante (22) und der dritten Kante (23) und eines vierten Abstandes (A4) zwischen der vierten Kante (24) und der fünften Kante (25), also A1 ≤ A2 + A4.

11. Klimaschrank (1) nach einem der vorgenannten Ansprüche, **dadurch gekennzeichnet, dass**
in der Dichtungsaufnahme (40) Befestigungsmittel (45) vorgesehen sind, durch die die Innenwandung (11) mit der Außenwandung (12) verbindbar ist.

12. Klimaschrank (1) nach einem der vorgenannten Ansprüche, **dadurch gekennzeichnet, dass**
der erste Abschnitt (31) mit dem zweiten Abschnitt (32) durch Verbindungsmittel verbunden ist.

13. Klimaschrank (1) nach einem der vorgenannten Ansprüche,
**dadurch gekennzeichnet, dass**
in der Wanne (15) eine Füllung aus einem thermisch isolierenden Werkstoff angeordnet ist, insbesondere aus einem ausgehärteten PUR- oder PIR-Kunststoffhartschaum.

14. Klimaschrank (1) nach einem der vorgenannten Ansprüche,
**dadurch gekennzeichnet, dass**
die Innenwandung (11) und/oder die Außenwandung (12) aus einem Edelstahl hergestellt sind bzw. ist.

## Claims

1. Climate chamber (1), comprising
- a housing, comprising at least one door (10), having an inner chamber which can be closed by means of the at least one door (10),
- wherein the at least one door (10) comprises an inner wall (11) and an outer wall (12),
- wherein the inner wall (11) is formed from a single-piece, flexible basic body which comprises a polygonal wall section (30) surrounded by lateral regions,
**characterized in that**
- one free end (36) of a tab (20) protrudes from each of the lateral regions,
- wherein a first edge (21) of the tab (20) is folded from the wall section (30) into a first section (31) in order to form a basin (15),
- wherein the free end (36) of the tab (20) is folded back through a second edge (22) into a second section (32) in order to form a sealing holder (40), into which a sealing can be inserted, and
- wherein the basin (15) is arranged on the side facing an outer side (8) in order to receive one or more thermally insulating layers and the sealing holder (40) is arranged on a side facing the inner side (7) for the sealing of the door.

2. Climate chamber (1) in accordance with claim 1,
**characterized in that**
the wall section (30) is implemented as a cuboid and **in that** a tab (20) protrudes at each of four lateral regions.

3. Climate chamber (1) in accordance with claim 1 or 2,
**characterized in that**
the second edge (22) is folded such that the second section (32) is arranged approximately parallel to the first section (21).

4. Climate chamber (1) in accordance with any of claims 1 to 3,
**characterized in that**
a third edge (23) and a fourth edge (24) are provided, **in that** the third edge (23) separates a third section (33) from the second section (32) toward the free end (36) of the tab (20), and **in that** the fourth edge (24) bends off a fourth section (34) from the third section (33) toward the free end (36) of the tab (20).

5. Climate chamber (1) in accordance with claim 4,
**characterized in that**
a first distance (A1) between the first edge (21) and the second edge (22) is larger than a second distance (A2) between the second edge (22) and the third edge (23).

6. Climate chamber (1) in accordance with claim 4 or 5,
**characterized in that**
the sealing holder (40) is U-shaped in its cross section and **in that** the sealing holder (40) is partially formed from the first section (31), from the third section (33) and from the fourth section (34).

7. Climate chamber (1) in accordance with any of claims 4 to 6,
**characterized in that**
the third section (33) forms a bottom (42) of the sealing holder (40) and is arranged approximately parallel to the wall section (30).

8. Climate chamber (1) in accordance with any of claims 4 to 7,
**characterized in that**
the fourth section (34) is arranged approximately parallel to the first section (31) and/or to the second section (32).

9. Climate chamber (1) in accordance with any of the preceding claims,
**characterized in that**
a fifth edge (25) is provided which forms, toward the free end (36) of the tab (20), an end section (35) which is arranged parallel to the wall section (30).

10. Climate chamber (1) in accordance with any of claims 4 to 9,
**characterized in that**
a first distance (A1) between the first edge (21) and the second edge (22) is smaller than the sum of a second distance (A2), between the second edge (22) and the third edge (23), and a fourth distance (A4), between the fourth edge (24) and the fifth edge (25), thus A1 ≤ A2 + A4.

11. Climate chamber (1) in accordance with any of the preceding claims,
**characterized in that**
fixing means (45) are provided in the sealing holder (40), by means of which the inner wall (11) can be attached to the outer wall (12).

12. Climate chamber (1) in accordance with any of the preceding claims,
**characterized in that**
the first section (31) is attached to the second section (32) by means of connecting elements.

13. Climate chamber (1) in accordance with any of the preceding claims,
**characterized in that**
a filling made of thermally insulating material is arranged in the basin (15), in particular of a hardened PUR or PIR synthetic hard foam.

14. Climate chamber (1) in accordance with any of the preceding claims,
**characterized in that**
the inner wall (11) and/or the outer wall (12) are(is) constructed of stainless steel.

## Revendications

1. Armoire de climatisation (1) comprenant :
- au moins un boîtier muni d'une porte (10) avec un volume intérieur qui se ferme avec cette porte (10),
- cette porte (10) ayant une paroi intérieure (11) et une paroi extérieure (12),
- la paroi intérieure (11) étant formée d'un corps de base en une seule pièce, pliable, et qui a un segment de paroi (30) polygonal entouré par des zones latérales,
**caractérisée en ce que**
une languette (20) étant en saillie respectivement des zones latérales par une extrémité libre (36),
- la languette (20) est repliée suivant une première arête (21) avec un premier segment (31) par rapport au segment de paroi (30) pour former une cuvette (15),
- l'extrémité libre (36) de la languette (20) étant repliée en arrière avec une seconde arête (22) en un second segment (32) pour former un logement de joint (40) recevant un joint, et
- la cuvette (15) pour recevoir une ou plusieurs couches d'isolation thermique était prévue sur le côté tourné vers le côté extérieur (8) et le logement de joint (40) pour le joint de porte est prévu sur le côté tourné vers le côté intérieur (7).

2. Armoire de climatisation (1) selon la revendication 1,
**caractérisée en ce que**
le segment de paroi (30) est de forme parallélépipédique et il comporte chaque fois une languette (20) en relief sur les quatre zones latérales.

3. Armoire de climatisation (1) selon la revendication 1 ou 2,
**caractérisée en ce que**
la seconde arête (22) est pliée de façon que le second segment (32) soit sensiblement parallèle au premier segment (31).

4. Armoire de climatisation (1) selon l'une des revendications 1 à 3,
**caractérisée par**
une troisième arête (23) et une quatrième arête (24),
sépare vers l'extrémité libre (36) de la languette (20), la troisième arête (23) un troisième segment (33) par rapport au second segment (32), et
- la quatrième arête (24) replie vers l'extrémité libre (36) de la languette (20), un quatrième segment (34) à partir du troisième segment (33).

5. Armoire de climatisation (1) selon la revendication 4,
**caractérisée en ce que**
une première distance (A1) entre la première arête (21) et la seconde arête (22) est supérieure à une seconde distance (A2) comprise entre la seconde arête (22) et la troisième arête (23).

6. Armoire de climatisation (1) selon la revendication 4 ou 5,
**caractérisée en ce que**
- le logement de joint (40) a une section en forme de U et,
- le logement de joint (40) se compose par zones, du premier segment (31), du troisième segment (33) et du quatrième segment (34).

7. Armoire de climatisation (1) selon l'une des revendications 4 à 6,
**caractérisée en ce que**
le troisième segment (33) forme un fond (42) du logement de joint (40) et il est sensiblement parallèle au segment de paroi (30).

8. Armoire de climatisation (1) selon l'une des revendications 4 à 7,
**caractérisée en ce que**
le quatrième segment (34) est sensiblement parallèle au premier segment (31) et/ou au second segment (32).

9. Armoire de climatisation (1) selon l'une des revendications précédentes,
**caractérisée en ce que**
il est prévu une cinquième arête (25) qui forme un segment d'extrémité (35) vers l'extrémité libre (36) de la languette (20), ce segment d'extrémité étant parallèle au segment de paroi (30).

10. Armoire de climatisation (1) selon l'une des revendications 4 à 9,
**caractérisée en ce que**
la première distance (A1) entre la première arête (21) et la seconde arête (22) est inférieure à la somme de la seconde distance (A2) entre la seconde arête (22) et la troisième arête (23) et de la quatrième distance (A4) entre la quatrième arête (24) et la cinquième arête (25) selon la relation A1≤A2+A4.

11. Armoire de climatisation (1) selon l'une des revendications précédentes,
**caractérisée en ce que**
des moyens de fixation (45) sont prévus dans le logement de joint (40) pour relier la paroi intérieure (11) à la paroi extérieure (12).

12. Armoire de climatisation (1) selon l'une des revendications précédentes,
**caractérisée en ce que**
le premier segment (31) est relié au second segment (32) par des moyens de liaison.

13. Armoire de climatisation (1) selon l'une des revendications précédentes,
**caractérisée en ce que**
un remplissage d'une matière d'isolation thermique est prévu dans la cuvette (15) notamment une mousse de matière synthétique durcie PUR ou PIR.

14. Armoire de climatisation (1) selon l'une des revendications précédentes,
**caractérisée en ce que**
la paroi intérieure (11) et/ou la paroi extérieure (12) sont en un acier inoxydable.
